# EUROPÄISCHE PATENTSCHRIFT

(11) **EP 0 433 573 B1**
(45) Veröffentlichungstag und Bekanntmachung des Hinweises auf die Patenterteilung: **02.11.1994**
(21) Anmeldenummer: 90118169.3
(22) Anmeldetag: 21.09.1990
(51) Int. Cl.: G01R 31/36

(54) **Vorrichtung zum Überprüfen des Funktionszustandes eines Akkumulators**
Device for monitoring the state of function of an accumulator
Dispositif de surveillance de l'état de fonctionnement d'un accumulateur

(30) Priorität: 21.12.1989 DE 3942288
(43) Veröffentlichungstag der Anmeldung: 26.06.1991
(73) Patentinhaber: SCHEIDT & BACHMANN GMBH, D-41238 Mönchengladbach (DE)
(72) Erfinder: Schürmanns, Peter, Dipl.-Ing.,, D-4050 Mönchengladbach 4 (DE); Laumen, Heinz, Dipl.-Ing.,, D-5133 Gangelt (DE)
(74) Vertreter: Stenger, Watzke & Ring Patentanwälte

(56) Entgegenhaltungen:
- EP-A- 0 067 589
- DE-C- 1 771 317
- GB-A- 2 185 326
- GB-A- 2 216 277
- KRAFTFAHRTECHNISCHES TASCHENBUCH, BOSCH, 20. AUFLAGE, VDI-VERLAG, 1987, S. 419

## Beschreibung

Die Erfindung betrifft eine Vorrichtung zum Überprüfen des Funktionszustandes eines Akkumulators, der im Bereitschafts-Parallelbetrieb ständig über einen Ladegleichrichter mit dem Netz und dem Verbraucher verbunden ist.

Um den Funktionszustand von Akkumulatoren, die im Bereitschafts-Parallelbetrieb ständig über den Ladegleichrichter mit dem Netz und dem Verbraucher verbunden sind, zu überprüfen, ist es bekannt, die Akkumulatoren turnusmäßig zu begutachten. Außer einer Überprüfung auf Schlammablagerungen wird hierbei der Ladungszustand der Akkumulatoren mittels eines Säurehebers ermittelt. Diese turnusmäßige Überwachung der nur für den Fall eines Netzausfalls bereitgehaltenen Akkumulatoren ist nicht nur aufwendig und kostspielig, sondern hat den entscheidenden Nachteil, daß sie keine Aussage über den eigentlichen Erhaltungszustand des Akkumulators ermöglicht. Aus diesem Grunde werden die Akkumulatoren nach bestimmten Einsatzzeiten ausgetauscht, und zwar unabhängig davon, ob sie noch funktionsfähig sind. Sofern geschlossene Batterien mit undurchsichtigem Gehäuse verwendet werden, versagt die bekannte Begutachtung.

Eine gattungsgemäße Vorrichtung zum Uberprüfen des Funktionszustandes eines Akkumulators und ein entsprechendes Verfahren sind in der GB-A-2 185 326 offenbart. Demgemäß wird die Zeitdifferenz gemessen, die beim testweise durchgeführten Lade- und Entladevorgang benötigt wird, um einen vorgegebenen Spannungswert zu erreichen. Die Akkumulatorbegutachtung entspricht der Bewertung der Zeitdifferenz, welche mit der sich aus einer Kennlinie für einen akzeptablen Akkumulator ergebenden Zeitdifferenz verglichen wird. Ist die gemessene Zeitdifferenz nicht in einem akzeptablen Wertebereich, ist der Akkumulator auszutauschen. Eine Temperaturkompensation findet nicht statt. Da darüber hinaus die Akkumulatoreigenschaften sehr stark von der aktuellen Stromabnahme abhängig sind, kann eine brauchbare Qualitätsaussage mit der vorbekannten Vorrichtung nur dann getroffen werden, wenn die Stromentnahme konstant ist.

Aus der EP-A-0 067 589 ist es bekannt, zum Überprüfen der Art und des Funktionszustandes eines Akkumulators eine Ladekennlinie aufzunehmen und diese mit einer dem Typ des jeweils verwendeten Akkumulators entsprechenden Kennlinie zu vergleichen. Dazu werden Kennlinien von Akkumulatoren nit unterschiedlichen Kapazitäten mit der Kennlinie des zu überprüfenden Akkumulators verglichen. Aus der Annäherung der gemessenen Kennlinie mit einer der vorgegebenen Kennlinien läßt sich dann ein Rückschluß auf den Zustand des Akkumulators ziehen. Gemäß dem aus der EP-A-0 067 589 Entnehmbaren ist es vorgesehen, beim Aufnehmen der Ladekennlinie mindestens bis zum Erreichen der Gasspannung zu gehen. Eine Temperaturkompensation findet nicht statt.

Die GB-A-2 216 277 offenbart ebenfalls ein Verfahren und eine Vorrichtung, bei welchen die Zeitdifferenz gemessen wird, die beim testweise durchgeführten Lade- und Entladevorgang eines Akkumulators benötigt wird, um einen vorgegebenen Spannungswert zu erreichen. Ein Bereitsschaftsparallelbetrieb der Batterie während des Einsatzes der vorbekannten Vorrichtung ist nicht möglich. Eine Temperaturkompensation findet ebenfalls nicht statt.

Der Erfindung liegt die Aufgabe zugrunde, eine Vorrichtung zum Uberprüfen des Funktionszustandes eines im Bereitschafts-Parallelbetrieb ständig über einen Ladegleichrichter mit dem Netz und mit dem Verbraucher verbundenen Akkumulators zu schaffen, die eine zuverlässige Aussage über den Funktionszustand ermöglicht und demzufolge die Möglichkeit schafft, auch geschlossene, wartungsfreie Batterien so lange zu verwenden, wie es ihr Funktionszustand zuläßt.

Die Lösung dieser Aufgabenstellung durch die Erfindung ist im Patentanspruch beschrieben.

Mit der erfindungsgemäßen Vorrichtung ist es möglich, eine definierte Aussage über den Funktionszustand des jeweils überprüften Akkumulators zu machen, da die periodisch erfolgende Ermittlung der aktuellen Entladungs- und Ladekennlinie des Akkumulators durch einen Vergleich mit der bauartbedingten Referenzkennlinie im Neuzustand des Akkumulators eine sichere Aussage über dessen Funktionszustand ermöglicht. Die erfindungsgemäße Vorrichtung arbeitet hierbei selbsttätig und ohne Energieverluste, da die zum Zwecke der Uberprüfung des Funktionszustandes des Akkumulators durchgeführte Entladung zur Versorgung des jeweiligen Verbrauchers verwendet wird. Auch während der Ermittlung der gesamten Kennlinie ist die Versorgung des Verbrauchers sichergestellt, so daß keinerlei Unterbrechung durch die Funktionsprüfung des Akkumulators eintritt.

Um den Einfluß der Temperatur bei der Überprüfung des Funktionszustandes eines Akkumulators mit der erfindungsgemäßen Vorrichtung zu berücksichtigen, sind in der Meßeinrichtung mehrere Referenzkennlinien für unterschiedliche Temperaturbereiche abzuspeichern. Von diesen Referenzkennlinien wird jeweils diejenige ausgewählt, die der aktuellen Temperatur entspricht.

Um den Einfluß verschiedener Stromstärden bei der Überprüfung des Funktionszustandes eines Akkumulators mit der erfindungsgemäßen Vorrichtung zu eliminieren, wird bei der Erfindung der Ladegleichrichter so gesteuert, daß die Stromwerte bei der Entladung und Nachladung des Akkumulators während eines Prüfzyklus immer einen fest definierten, von der Grundlast der Anlage unabhängigen Wert haben.

In der Zeichnung sind ein Ausführungsbeispiel der erfindungsgemäßen Vorrichtung und zugehörige Kennlinien dargestellt, und zwar zeigen:
- Fig. 1: ein Schaltbild der Vorrichtung und
- Fig. 2: ein Diagramm mit mehreren Kennlinien.

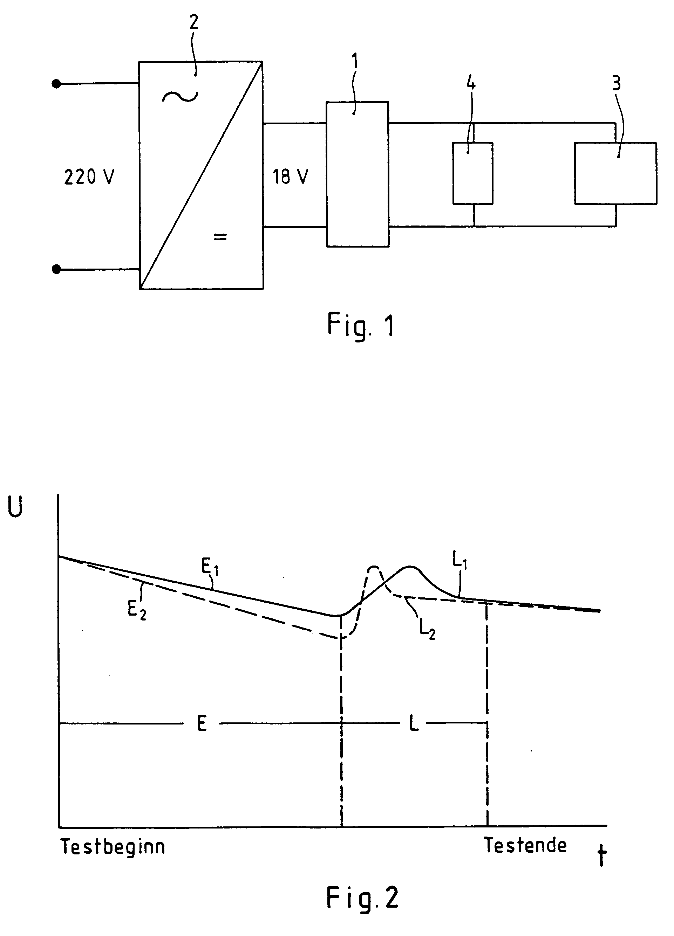

Das Schaltbild in Fig.1 zeigt einen Akkumulator 1, der ständig über einen Ladegleichrichter 2 an das Netz angeschlossen ist, das beim Ausführungsbeispiel eine Spannung von 220 Volt hat, wogegen der Akkumulator eine Spannung von 18 Volt liefert. Mit dieser Spannung von 18 Volt wird ein Verbraucher 3 betrieben, der ebenfalls in Fig.1 dargestellt ist.

Parallel zum Akkumulator 1 ist eine Meßeinrichtung 4 angeordnet, welche die nachfolgend beschriebenen Eigenschaften und Funktionen hat.

Mit Hilfe dieser Meßeinrichtung 4 wird zum Uberprüfen des Funktionszustandes des Akkumulators 1 bei Grundlast für eine vorgebbare Zeit eine definierte Absenkung der Leistung des Ladegleichrichters 2 bewirkt. Die Meßeinrichtung 4 steuert demgemäß die Leistung des Ladegleichrichters 2.

Aufgrund dieser definierten, in der Höhe anlagenspezifischen Absenkung der Leistung des Ladegleichrichters 2 erfolgt durch den weiterhin mit Grundlast betriebenen Verbraucher 3 eine definierte Entladung des Akkumulators 1. Die hierdurch entstehende Entladungskennlinie E gemäß dem Diagramm in Fig.2 von der Meßeinrichtung 4 aufgenommen. Bei einem neuen bzw. voll funktionsfähigen Akkumulator 1 ergibt sich die obere, mit ausgezogenen Linien dargestellte Entladungskennlinie E₁. Handelt es sich dagegen um einen nur noch bedingt funktionsfähigen Akkumulator 1, ergibt sich die stärker abfallende Entladungskennlinie E₂.

Nach Aufzeichnen dieser Entladungskennlinie E₁ bzw. E₂ wird der Ladegleichrichter 2 von der Meßeinrichtung 4 derart angesteuert, daß er mit einer die Grundlast um einen definierten Ladestrom übersteigenden Leistung betrieben wird, und zwar bis zum Erreichen der Gasungsspannung des Akkumulators 1. Da der Akkumulator 1 zuvor über eine bestimmte Zeitspanne zur Versorgung des Verbrauchers 3 mit herangezogen worden ist, schließt sich an die teilweise Entladung des Akkumulators 1 nunmehr eine Wiederaufladung an. Die hierbei entstehende Ladekennlinie L wird von der Meßeinrichtung 4 aufgenommen. Die Ladekennlinie L umfaßt bei Erreichen der Gasungsspannung ein Maximum und sinkt anschließend mehr oder weniger langsam auf eine Erhaltungsladespannung ab. Da das Erreichen der effektiven Erhaltungsladespannung unerheblich ist, wird die Ladekennlinie L nur bis zu einem vorgebbaren Testende aufgezeichnet, wie dies dem Diagramm in Fig.2 zu entnehmen ist.

Dieses Diagramm in Fig.2 zeigt, daß ein neuwertiger Akkumulator 1 die Gasungsspannung nach einem normalen Anstieg erreicht und daß nach Erreichen der Gasungsspannung die Spannung entsprechend gleichmäßig auf die Erhaltungsladespannung absinkt. Die entsprechende Ladekennlinie ist im Diagramm mit L₁ bezeichnet. Ein Akkumulator 1 mit herabgesetzter Funktionsfähigkeit erreicht gemäß der Ladekennlinie L₂ die Gasungsspannung schneller und nach einem erheblich steileren Anstieg. Entsprechend fällt die Spannung schneller und steiler ab, um verhältnismäßig schnell die Erhaltungsladespannung zu erreichen.

In der Meßeinrichtung 4 wird die gesamte, aus Entladungskennlinie E und Ladekennlinie L bestehende Kennlinie des jeweils überprüften Akkumulators 1 mit der bauartbedingten Referenzkennlinie im Neuzustand des betreffenden Akkumulators 1 verglichen. Beim Ausführungsbeispiel stellen die Entladungskennlinie E₁ und die Ladekennlinie L₁ die Referenzkennlinie des Akkumulators 1 dar. Bei den Kennlinien E₂ und L₂ handelt es sich um beim Uberprüfungsvorgang durch die Meßeinrichtung 4 in der voranstehend beschriebenen Weise ermittelte Kennlinien.

In der Meßeinrichtung 4 werden nunmehr die aufgenommenen Kennlinien mit der Referenzkennlinie verglichen. Sobald eine definierte Abweichung zwischen den beiden Kennlinien eintritt, gibt die Meßeinrichtung 4 eine Meldung ab, aus der hervorgeht, daß der überprüfte Akkumulator 1 nunmehr gegen einen neuwertigen Akkumulator 1 ausgetauscht werden muß, da seine Funktionsfähigkeit derart abgenommen hat, daß er bei Ausfall des Netzes nicht mehr in der Lage ist, für eine vorgegebene Zeit eine Versorgung des Verbrauchers 3 sicherzustellen.

Da die Entladungs- und Ladekennlinie E bzw. L eines Akkumulators 1 maßgeblich von der jeweils herrschenden Temperatur beeinflußt werden, können in der Meßeinrichtung 4 mehrere Referenzkennlinien abgespeichert werden, und zwar jeweils für unterschiedliche Temperaturbereiche. Bei der Durchführung des voranstehend beschriebenen Überprüfungsvorganges wird durch eine Temperaturmessung jeweils diejenige Referenzkennlinie zum Vergleich herangezogen, die für die jeweils herrschende Temperatur maßgeblich ist.

## Patentansprüche

1. Vorrichtung zum Überprüfen des Funktionszustandes eines Akkumulators, der im Bereitschafts-Parallelbetrieb ständig über einen Ladegleichrichter mit dem Netz und mit dem Verbraucher verbunden ist, anhand eines Kennlinienvergleiches, wobei parallel zum Akkumulator (1) eine Meßeinrichtung (4) angeordnet ist,
**dadurch gekennzeichnet,**
daß die Meßeinrichtung (4)
a) bei Grundlast für eine vorgebbare Zeit eine definierte Absenkung der Leistung des Ladegleichrichters (2) bewirkt und die bei der hierdurch eintretenden Konstantstromentladung des Akkumulators (1) entstehende Entladungskennlinie (E₂) aufzeichnet,
b) anschließend den Ladegleichrichter (2) derart ansteuert, daß er mit einer die Grundlast um einen definierten Ladestrom übersteigenden Leistung bis zum Erreichen der Gasungsspannung des Akkumulators (1) betrieben wird und die hierbei entstehende Ladekennlinie (L₂) sowie das anschließende Absinken auf die Erhaltungsladespannung bei definierter konstanter Stromentnahme aufnimmt und
c) die gesamte, aus Entladekennlinie (E) und Ladekennlinie (L) bestehende Kennlinie (E₂, L₂) mit der bauartbedingten Referenzkennlinie (E₁, L₁) im Neuzustand des betreffenden Akkumulators (1) vergleicht und bei einer definierten Abweichung eine Meldung abgibt, und
daß in der Meßeinrichtung (4) mehrere Referenzkennlinien für unterschiedliche Temperaturbereiche abgespeichert sind.

## Claims

1. Device for checking the function state of a storage battery, which in standby parallel operation is permanently connected via a charging rectifier to the mains and to the load, with the aid of a comparison of characteristics, a measuring device (4) being arranged in parallel with the storage battery (1), characterized in that the measuring device (4)
a) effects a defined reduction in the output of the charging rectifier (2) when there is a base load for a prescribable time, and records the discharging characteristic (E₂) produced given the constant-current discharge of the storage battery (1) thereby occurring,
b) subsequently drives the charging rectifier (2) in such a way that it is operated with an output exceeding the base load by a defined charging current until the gassing voltage of the storage battery (1) is reached, and records the charging characteristic (L₂) thereby produced as well as the subsequent drop to the top-up charging voltage given a defined constant current drain, and
c) compares the overall characteristic (E₂, L₂) consisting of the discharging characteristic (E) and charging characteristic (L) with the design-induced reference characteristic (E₁, L₁) in the new state of the relevant storage battery (1) and emits a signal given a defined deviation, and
in that a plurality of reference characteristics for different temperature ranges are stored in the measuring device (4).

## Revendications

1. Dispositif pour le contrôle de l'état de fonctionnement d'un accumulateur qui est relié en permanence, pour une alimentation continuelle d'énergie, par l'intermédiaire d'un redresseur de charge, au réseau et à l'appareil utilisateur, et ce, au moyen d'une comparaison de courbes caractéristiques, un appareil de mesure (4) étant disposé parallèlement à l'accumulateur (1),
caractérisé en ce que le dispositif de mesure (4).
a) provoque en présence d'une charge de base, pour une durée prédéfinissable, une réduction définie du rendement du redresseur de charge (2) et trace la courbe caractéristique de décharge (E₂) produite du fait de la décharge en courant constant de l'accumulateur (1) ainsi provoquée,
b) commande ensuite le redresseur de charge (2) de telle manière que celui-ci fonctionne avec un rendement dépassant, de la valeur d'un courant de charge défini, la charge de base, jusqu'à ce que soit atteinte la tension du début de dégagement gazeux de l'accumulateur (1), et en ce qu'il enregistre la courbe caractéristique de charge (L₂) ainsi produite ainsi que la baisse, qui fait suite, jusqu'à la tension de charge de compensation, pour un prélèvement de courant constant défini, et
c) en ce qu'il compare la courbe caractéristique complète (E₂, L₂), composée de la courbe caractéristique de décharge (E) et de la courbe caractéristique de charge (L), à la courbe caractéristique de référence (E₁, L₁) qui est fonction du type de l'accumulateur (1) concerné à l'état neuf, et en ce qu'il émet un message dans le cas d'un écart défini, et
en ce que plusieurs courbes caractéristiques de référence sont mémorisées dans le dispositif de mesure(4), pour des plages de températures différentes.
